# EUROPEAN PATENT SPECIFICATION

(11) **EP 4 418 313 B1**
(45) Date of publication and mention of the grant of the patent: **30.07.2025**
(21) Application number: 21964320.2
(22) Date of filing: 16.11.2021
(51) Int. Cl.: H10D 30/01, H10D 84/01, H10D 84/03, H10D 84/83, H10D 89/10

(54) **CHIP, MANUFACTURING METHOD FOR CHIP, AND ELECTRONIC DEVICE**
CHIP, HERSTELLUNGSVERFAHREN FÜR CHIP UND ELEKTRONISCHE VORRICHTUNG
PUCE, PROCÉDÉ DE FABRICATION DE PUCE, ET DISPOSITIF ÉLECTRONIQUE

(43) Date of publication of application: 21.08.2024
(73) Proprietor: Huawei Technologies Co., Ltd., Shenzhen, Guangdong 518129 (CN)
(72) Inventor: YANG, Lei, Shenzhen, Guangdong 518129 (CN); GAO, Jian, Shenzhen, Guangdong 518129 (CN); WU, Eric, Shenzhen, Guangdong 518129 (CN); YE, John, Shenzhen, Guangdong 518129 (CN)
(74) Representative: Thun, Clemens
(86) International application number: PCT/CN2021/131001
(87) International publication number: WO 2023/087154

(56) References cited:
- CN-A- 102 760 732
- CN-A- 107 393 921
- CN-A- 108 878 364
- US-A1- 2015 076 569
- US-A1- 2019 189 609
- US-A1- 2021 257 351

## Description

### TECHNICAL FIELD

This application relates to the field of semiconductor technologies, and in particular, to a chip, a chip manufacturing method, and an electronic device.

### BACKGROUND

With the development of electronic technologies, a fin field effect transistor (fin field effect transistor, FinFET), as a new field effect transistor, is widely used in various chips. The fin field effect transistor includes a gate and a strip-shaped fin structure. The gate surrounds the fin structure from three surfaces, and the gate can control a channel region through a top surface and two side surfaces of the fin structure. This can greatly improve a gate control capability, and significantly reduce a leakage current. Therefore, the fin field effect transistor has advantages such as a strong gate control capability, a small device size, and low power consumption.

In a related technology, in a manufacturing process of a fin field effect transistor, after a plurality of fins are formed on a substrate, a fin outside an active region needs to be removed, to form a fin structure in the active region. Because a region except the active region usually has a complex shape, precision of a process for removing the fin is low, and a shape of the fin structure in the active region is prone to be affected. In addition, the fin in the region except the active region is removed, resulting in a large process difference between the region except the active region and the active region. This causes poor uniformity of a subsequently formed isolation dielectric layer, further affects growth of a subsequent film layer, and is prone to drawbacks such as bending and dislocation of the fin structure due to uneven stress. Consequently, the fin field effect transistor manufactured in the related technology has poor performance. US 2021/257351 A1 discloses a fin field effect transistor and a manufacturing method therefore, as known in the prior art.

### SUMMARY

Embodiments of this application provide a chip, a chip manufacturing method, and an electronic device, to resolve a problem that a fin field effect transistor manufactured in a related technology has poor performance.

According to a first aspect, an embodiment of this application provides a chip manufacturing method, and the manufacturing method may include:

A substrate is provided, where a surface of the substrate has a plurality of active regions, a plurality of first strip-shaped regions extending in a first direction, a plurality of second strip-shaped regions extending in a second direction, and a plurality of dummy regions. The dummy region is located in a region except the plurality of active regions, the plurality of first strip-shaped regions, and the plurality of second strip-shaped regions. The first direction and the second direction intersect each other, for example, the first direction and the second direction may be perpendicular to each other. Each active region corresponds to at least one fin field effect transistor to be formed, and each active region is surrounded by a region formed by the first strip-shaped region and/or the second strip-shaped region. For example, when the active region is rectangular, the active region may be surrounded by two first strip-shaped regions and two second strip-shaped regions. In actual application, the active region may be set in a shape like a rectangle or an "L" shape, and may be set based on a structure of the fin field effect transistor to be formed. In addition, shapes and positions of the plurality of first strip-shaped regions and second strip-shaped regions may be set based on shapes and relative positions of the plurality of active regions on the substrate.

Then, a plurality of fins are formed on the substrate. Optionally, the plurality of formed fins may approximately cover the surface of the substrate, that is, fins are distributed in each of the following: the active regions, the first strip-shaped regions, the second strip-shaped regions, and the dummy regions. During specific implementation, the plurality of fins extending in the first direction may be formed on the substrate, that is, the fins formed on the substrate have a same extension direction, and the extension direction of the fin is consistent with the extension direction of the first strip-shaped region.

Then, fins in the plurality of first strip-shaped regions and the plurality of second strip-shaped regions are removed, to form a fin structure of a fin field effect transistor in each active region, and form a dummy fin structure in each dummy region, where the fin structure is some fins located in the active region, and the dummy fin structure is some fins located in the dummy region.

According to the chip manufacturing method provided in this embodiment of this application, the plurality of first strip-shaped regions and the plurality of second strip-shaped regions are disposed. The first strip-shaped region extends in the first direction, the second strip-shaped region extends in the second direction, and each active region is surrounded by the region formed by the first strip-shaped region and/or the second strip-shaped region. In this way, after the fins in the plurality of first strip-shaped regions and the plurality of second strip-shaped regions are removed, the fin structure of the fin field effect transistor can be formed in each active region, and the dummy fin structure can be formed in the dummy region except the active region, the first strip-shaped region, and the second strip-shaped region. The dummy fin structure is spaced from the fin structure in the active region by the first strip-shaped region and the second strip-shaped region, so that the dummy fin structure does not affect performance of the fin structure in the active region. In addition, the dummy fin structure is disposed, so that a subsequently formed isolation dielectric layer can be uniform, quality of a subsequently formed film layer can be good, and drawbacks such as bending and dislocation of the fin structure due to uneven stress can be prevented. In addition, the shapes of the first strip-shaped region and the second strip-shaped region are simple. This reduces difficulty of a process for removing the fin, and does not affect a shape of the fin structure in the active region. Therefore, the fin field effect transistor obtained in the chip manufacturing method provided in this embodiment of this application has good performance.

In this embodiment of this application, each active region may include at least two first edges extending in the first direction, and at least two second edges extending in the second direction. Each first strip-shaped region is adjacent to a first edge of at least one active region, and each second strip-shaped region is adjacent to a second edge of the at least one active region. In other words, the active region is close to the first strip-shaped region and the second strip-shaped region that surround the active region, so that after the fins in the first strip-shaped region and the second strip-shaped region are removed, the fin structure formed is substantially located within a range of each active region, and manufacturing precision of the fin structure is high. In addition, there may be a specific gap between the active region and the first strip-shaped region and the second strip-shaped region that surround the active region. This can avoid affecting the shape of the fin structure in the active region in a process of removing the fins in the first strip-shaped region and the second strip-shaped region due to a process error, and can further ensure that the fin structure formed in the active region has good performance.

In a possible implementation, a width of the first strip-shaped region in the second direction may be within a range of 0-2000 nm, and a width of the second strip-shaped region in the first direction is within a range of 0-2000 nm. In this way, the widths of the first strip-shaped region and the second strip-shaped region are appropriately set, a size of the dummy region except the active region, the first strip-shaped region, and the second strip-shaped region can be controlled, and the widths of the first strip-shaped region and the second strip-shaped region can be narrowed, so that an area of the removed fin is smaller, an area of the formed dummy fin structure can be larger, and a process difference between a region except each active region and the active region is small. This can achieve effect of process optimization, and ensure that the formed fin field effect transistor has good performance.

In a possible implementation, that fins in the plurality of first strip-shaped regions and in the plurality of second strip-shaped regions are removed may include:
Fins in the plurality of first strip-shaped regions are removed by using a photolithography process and an etching process; and
Fins in the plurality of second strip-shaped regions are removed by using a photolithography process and an etching process.

In an actual process, in the process of removing the fins in the first strip-shaped region and the second strip-shaped region, process precision and a process window can be improved by adjusting conditions of the photolithography process such as a light source and an exposure parameter and an etching process condition.

In this embodiment of this application, an example in which the fins in the plurality of first strip-shaped regions are first removed, and then, the fins in the plurality of second strip-shaped regions are removed is used for description. In the actual process, the fins in the plurality of second strip-shaped regions may alternatively be removed first, and then, the fins in the plurality of first strip-shaped regions are removed, or the fins in the plurality of first strip-shaped regions and the plurality of second strip-shaped regions may be removed at the same time. This is not limited herein.

In a possible implementation, that a plurality of fins are formed on the substrate may include:
A plurality of mandrels are formed on the substrate, where extension directions of the mandrels are the same as extension directions of the fins to be formed. Optionally, a polycrystalline silicon material may be used to manufacture the mandrel. Certainly, another material may alternatively be used to manufacture the mandrel. This is not limited herein. In an actual process, an entire mandrel film layer may be formed on the substrate, and then the plurality of mandrels located on the substrate are obtained by using the etching process.

A side wall layer is formed on an entire surface of the mandrels. During specific implementation, a silicon nitride material may be used to manufacture the side wall layer, and certainly, another material may alternatively be used to manufacture the side wall layer. This is not limited herein. Then, the side wall layer is etched to form a plurality of side walls located on side walls of the mandrels. In an actual process, the entire side wall layer may be etched, and due to geometrical effect of the side wall of the mandrel, a material on the side wall of the mandrel is not etched, so that the side wall is formed on the side wall of the mandrel.

The plurality of mandrels are removed by using an etching process.

The substrate is etched by using the plurality of side walls as shielding, to obtain patterns of the plurality of fins.

The plurality of side walls are removed to obtain the plurality of fins.

In this embodiment of this application, the foregoing manufacturing procedure is used as an example to describe a manufacturing process of the fin. In an actual process, the fin may alternatively be manufactured in another manner. This is not limited herein.

In some embodiments of this application, after the fin structure of the fin field effect transistor is formed, the method may further include:

Doping processing is performed on the fin structure in each active region, to form a source region, a drain region, and a channel region in the fin structure, where the channel region may be located between the source region and the drain region. In a process of doping the fin structure in the active region, the dummy fin structure in the dummy region may also be doped, so that the dummy region does not need to be shielded, thereby simplifying process difficulty.

An isolation dielectric layer is formed on the surface of the substrate, and the isolation dielectric layer is etched, so that each fin structure protrudes from the isolation dielectric layer. In this embodiment of this application, an entire surface of the isolation dielectric layer may be approximately formed on the surface of the substrate. After the isolation dielectric layer is etched, each dummy fin structure may further protrude from the isolation dielectric layer. Because there is the dummy fin structure in the dummy region except the active region, the first strip-shaped region, and the second strip-shaped region, the formed isolation dielectric layer can be uniform.

A gate dielectric layer is formed on the fin structure in each active region, and the gate dielectric layer may cover the channel region in the fin structure.

A gate is formed at the gate dielectric layer in each active region, to obtain at least one fin field effect transistor. Because the isolation dielectric layer formed in this embodiment of this application is uniform, the gate dielectric layer and the gate that are subsequently formed have good quality, and the obtained fin field effect transistor has good performance.

In an actual process, the gate dielectric layer and the gate may also be formed on the dummy fin structure, so that a process difference between the active region and the dummy region is small. In addition, after the doping process, a source electrically connected to the source region in the fin structure may further be formed, and a drain electrically connected to the drain region in the fin structure may be formed, thereby connecting the source region and the drain region in the fin structure. Because the dummy fin structure only performs a function of enabling the subsequently formed isolation dielectric layer to be uniform, and does not need to be electrically connected to another component, a source region and a drain region in the dummy fin structure do not need to be connected.

According to a second aspect, an embodiment of this application further provides a chip. The chip may include a substrate and a plurality of fin structures and a plurality of dummy fin structures that are located on the substrate. A surface of the substrate may have a plurality of active regions, a plurality of first strip-shaped regions extending in a first direction, a plurality of second strip-shaped regions extending in a second direction, and a plurality of dummy regions, where the dummy regions may be located in regions except the active regions, the plurality of first strip-shaped regions, and the plurality of second strip-shaped regions. The first direction and the second direction intersect each other, for example, the first direction and the second direction may be perpendicular to each other. At least one fin structure is disposed in each active region on the substrate, and at least one dummy fin structure is disposed in each dummy region on the substrate. Each active region and the dummy region are spaced by the first strip-shaped and/or the second strip-shaped.

In this embodiment of this application, each active region corresponds to at least one fin field effect transistor, that is, the chip includes at least one fin field effect transistor. Each active region and the dummy region are spaced by the first strip-shaped region and/or the second strip-shaped region. Therefore, the fin structure in each active region is disposed to be spaced from the dummy fin structure in the dummy region, so that the dummy fin structure does not affect performance of the fin structure.

In addition, in the dummy regions on the surface of the substrate, a shape of at least one dummy region is a polygon including at least five sides, that is, the polygon may include five, six, or more sides, and may be set based on positions and shapes of the active regions on the surface of the substrate. The dummy region includes at least one sub-region, the sub-region is surrounded by at least three sides in the polygon, and the sub-region is embedded into a gap between two adjacent active regions. In a possible implementation, the sub-region may be a closed region enclosed by at least three sides in the polygon and a line segment (which may alternatively be a polyline, a curve, or the like) located in the dummy region.

In this way, space between two adjacent active regions can be fully utilized, and a larger quantity of dummy fin structures can be disposed near the active region, so that an area of the dummy region can be larger, uniformity of a subsequently formed isolation dielectric layer can be greatly improved, further, a subsequently formed film layer has good quality, and the fin field effect transistor has good performance.

In a possible implementation, at least one of the plurality of dummy regions on the surface of the substrate at least semi-encloses one active region, and the dummy region may semi-enclose one, two, or more active regions. Alternatively, the dummy region may fully enclose at least one active region. This is not limited herein. It may be understood that the dummy region at least semi-enclosing one active region means that the dummy region encloses at least two sides of the active region.

Optionally, at least one of the plurality of dummy regions on the surface of the substrate may be a rectangle.

During specific implementation, at least one of the plurality of active regions on the surface of the substrate is rectangular, and the active region and the dummy region are spaced by two first strip-shaped regions and two second strip-shaped regions. Certainly, the active region may alternatively be in another shape. For example, the active region may be in an "L" shape, and quantities and positions of the first strip-shaped regions and the second strip-shaped regions that surround the active region may be set based on the shape of the active region.

In a possible implementation, the chip may further include an isolation dielectric layer located on the substrate, and the fin structure protrudes from a side that is of the isolation dielectric layer and that is away from the substrate. In addition, the chip may further include a gate dielectric layer and a gate in the active region located on the substrate. The gate is located on a side that is of the fin structure and that is away from the substrate, and the gate dielectric layer is located between the fin structure and the gate. The fin structure includes a source region, a drain region, and a channel region, the channel region is located between the source region and the drain region, the gate covers a position of the channel region in the fin structure, and a top surface and two side surfaces of the fin structure are both surrounded by the gate. Therefore, the gate can control the channel region through the top surface and the two side surfaces of the fin structure, so that the fin field effect transistor has advantages such as a strong gate control capability, a small device size, and low power consumption.

According to a third aspect, an embodiment of this application further provides an electronic device. The electronic device may be a device like a smartphone, a smart television, or a notebook computer. The electronic device may include any one of the chips and a printed circuit board. Because the fin field effect transistor in the chip has good performance, the electronic device including the chip also has good performance.

### BRIEF DESCRIPTION OF DRAWINGS

FIG. 1 is a schematic of a structure of a fin field effect transistor;
FIG. 2 is a flowchart of a chip manufacturing method according to an embodiment of this application;
FIG. 3, FIG. 4, FIG. 5a, FIG. 5b, and FIG. 6 are schematics of structures corresponding to steps in a chip manufacturing method according to an embodiment of this application;
FIG. 7 to FIG. 12 are flowcharts of a manufacturing process of a fin according to an embodiment of this application;
FIG. 13a is a schematic of a structure of a plurality of fins formed on a substrate;
FIG. 13b is a schematic of a cross section at a dashed line WW' in FIG. 13a;
FIG. 14a is a schematic of a structure of a process of removing fins in a plurality first strip-shaped regions;
FIG. 14b is a schematic of a cross section at a dashed line PP' in FIG. 14a;
FIG. 15a is a schematic of a structure obtained by removing fins in a plurality of first strip-shaped regions;
FIG. 15b is a schematic of a cross section at a dashed line PP' in FIG. 15a;
FIG. 16a is a schematic of a structure of a process of removing fins in a plurality second strip-shaped regions;
FIG. 16b is a schematic of a cross section at a dashed line QQ' in FIG. 16a;
FIG. 17a is a schematic of a structure obtained by removing fins in a plurality of second strip-shaped regions;
FIG. 17b is a schematic of a cross section at a dashed line QQ' in FIG. 17a; and
FIG. 18 to FIG. 20 are schematics of structures corresponding to steps in a chip manufacturing method according to an embodiment of this application.

Reference numerals:
10: substrate; 11: fin; 111: fin structure; 112: dummy fin structure; 12: isolation dielectric layer; 13: gate; 14: gate dielectric layer; 15: mandrel; 16: side wall layer; 161: side wall; 17: buffer layer; 18: protective layer; A1 to A7: active region; T1: first strip-shaped region; T2: second strip-shaped region; C1, C2, and C3: dummy region; a: first edge; and b: second edge.

### DESCRIPTION OF EMBODIMENTS

To make objectives, technical solutions, and advantages of this application clearer, the following further describes this application in detail with reference to accompanying drawings.

It should be noted that same reference numerals in the accompanying drawings of this application indicate same or similar structures, and therefore repeated descriptions thereof are omitted. Words for expressing positions and directions in this application are described by using the accompanying drawings as examples. However, changes may be made as required, and all changes shall fall within the protection scope of this application. The accompanying drawings in this application are merely used to show a relative positional relationship, and do not indicate a true scale.

Embodiments of this application provide a chip, a chip manufacturing method, and an electronic device. The chip may be a central processing unit chip, an artificial intelligence chip, or the like. Certainly, the chip may alternatively be a chip of another type. This is not limited herein. The chip provided in embodiments of this application is applied to various types of electronic devices. For example, the electronic device may be a smartphone, a smart television, a notebook computer, or the like.

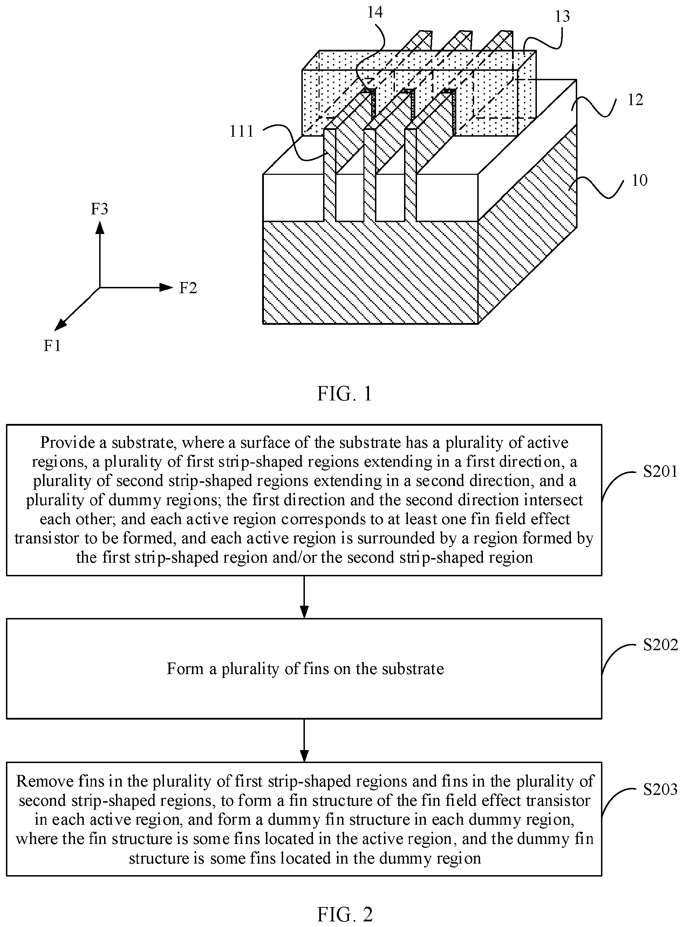

The chip provided in embodiments of this application may include at least one fin field effect transistor. FIG. 1 is a schematic of a structure of a fin field effect transistor. As shown in FIG. 1, the fin field effect transistor may include a substrate 10, at least one fin structure 111 located on the substrate 10, an isolation dielectric layer 12 located on the substrate 10, a gate 13 located on a side that is of the fin structure 111 and that is away from the substrate 10, and a gate dielectric layer 14 located between the fin structure 111 and the gate 13. The fin structure 111 is a strip-shaped structure extending in a first direction F1, and the fin structures 111 are arranged in a second direction F2. The first direction F1 and the second direction F2 intersect each other, and a third direction F3 may be a direction perpendicular to a surface of the substrate 10. FIG. 1 shows an example in which the fin field effect transistor includes three fin structures 111. During specific implementation, the fin field effect transistor may alternatively include one, two, four, or more fin structures 111. A quantity of fin structures 111 is not limited herein. The fin structure 111 protrudes from a side that is of the isolation dielectric layer 12 and that is away from the substrate 10. The fin structure 111 includes a source region, a drain region, and a channel region, the gate 13 covers a position of the channel region in the fin structure 11, and a top surface and two side surfaces of the fin structure 111 are both surrounded by the gate 13. Therefore, the gate 13 can control the channel region through the top surface and the two side surfaces of the fin structure 111, so that the fin field effect transistor has advantages such as a strong gate control capability, a small device size, and low power consumption.

The following describes in detail the chip, the chip manufacturing method, and the electronic device provided in embodiments of this application with reference to the accompanying drawings.

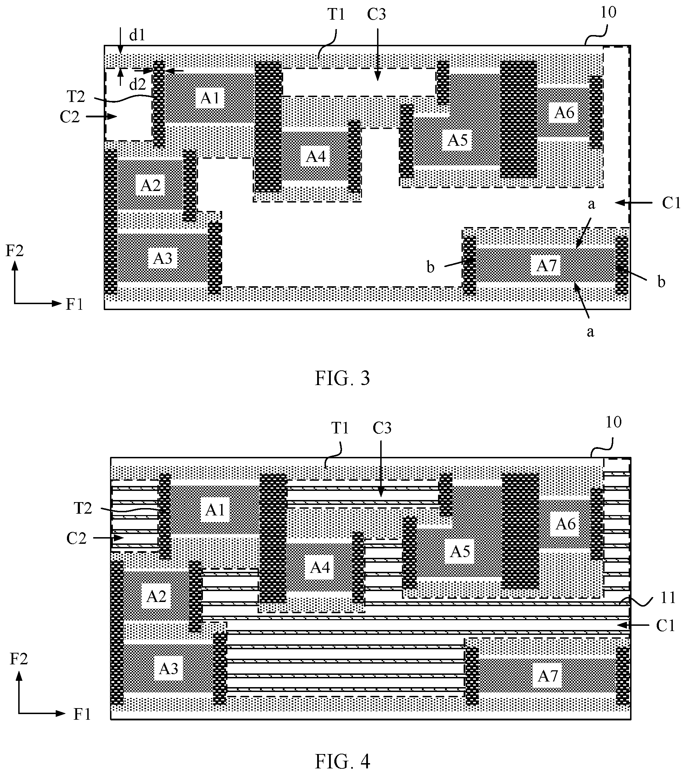

FIG. 2 is a flowchart of a chip manufacturing method according to an embodiment of this application, and FIG. 3, FIG. 4, FIG. 5a, FIG. 5b, and FIG. 6 are schematics of structures corresponding to steps in the chip manufacturing method according to this embodiment of this application. As shown in FIG. 2, the chip manufacturing method provided in this embodiment of this application may include the following steps.

S201: As shown in FIG. 3, provide a substrate 10.

A surface of the substrate 10 has a plurality of active regions (for example, the surface of the substrate 10 in FIG. 3 has active regions A1 to A7), a plurality of first strip-shaped regions T1 extending in a first direction F1, a plurality of second strip-shaped regions T2 extending in a second direction F2, and a plurality of dummy regions (for example, the surface of the substrate 10 in FIG. 3 has dummy regions C1 to C3). The dummy regions C1 to C3 are located in regions except the plurality of active regions, the plurality of first strip-shaped regions T1, and the plurality of second strip-shaped regions T2. The first direction F1 and the second direction F2 intersect each other, for example, the first direction F1 and the second direction F2 may be perpendicular to each other. Each active region corresponds to at least one fin field effect transistor to be formed, and each active region is surrounded by a region formed by the first strip-shaped region T1 and/or the second strip-shaped region T2. For example, in FIG. 3, the active regions A1, A2, A3, A4, A6, and A7 each are surrounded by a region formed by two first strip-shaped regions T1 and two second strip-shaped regions T2.

During specific implementation, at least two adjacent active regions may share the first strip-shaped region T1 or the second strip-shaped region T2. For example, in FIG. 3, the active region A2 and the active region A3 share a same second strip-shaped region T2, the active region A1 and the active region A4 share a same second strip-shaped region T2, and the active region A5 and the active region A6 share a same second strip-shaped region T2. Alternatively, at least two active regions whose edges are basically aligned may share a first strip-shaped region T1 or a second strip-shaped region T2. For example, in FIG. 3, the active region A1, the active region A5, and the active region A6 share a same first strip-shaped region T1, and the active region A3 and the active region A7 may share a same first strip-shaped region T1. It should be noted that in FIG. 3, an example in which the active regions A1, A2, A3, A4, A6, and A7 are rectangular, and the active region A5 is in an "L" shape is used for description. In actual application, the active region may alternatively be in another shape, and the shape may be set based on a structure of a fin field effect transistor to be formed. In addition, shapes and positions of the plurality of first strip-shaped regions T1 and second strip-shaped regions T2 may be set based on shapes and relative positions of the active regions on the substrate 10.

S202: As shown in FIG. 4, form a plurality of fins 11 on the substrate 10. Optionally, the plurality of formed fins 11 may approximately cover the surface of the substrate 10, that is, fins 11 are distributed in each of the following: the active regions A1 to A7, the first strip-shaped regions T1, the second strip-shaped regions T2, and the dummy regions C1 to C3.

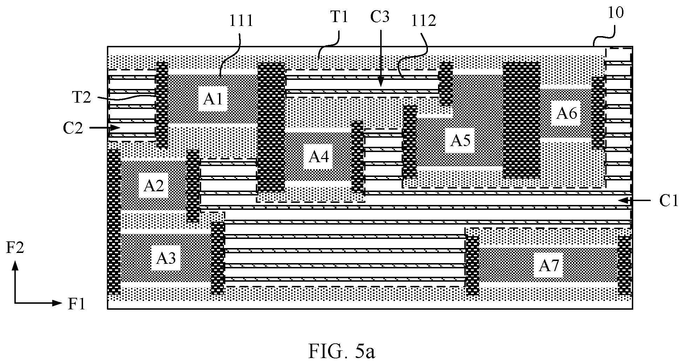

S203: As shown in FIG. 5a, remove fins in the plurality of first strip-shaped regions T1 and the plurality of second strip-shaped regions T2, to form a fin structure 111 of a fin field effect transistor in each active region, and form a dummy fin structure 112 in each dummy region. The fin structure 111 is some fins located in the active region, and the dummy fin structure 112 is some fins located in the dummy region.

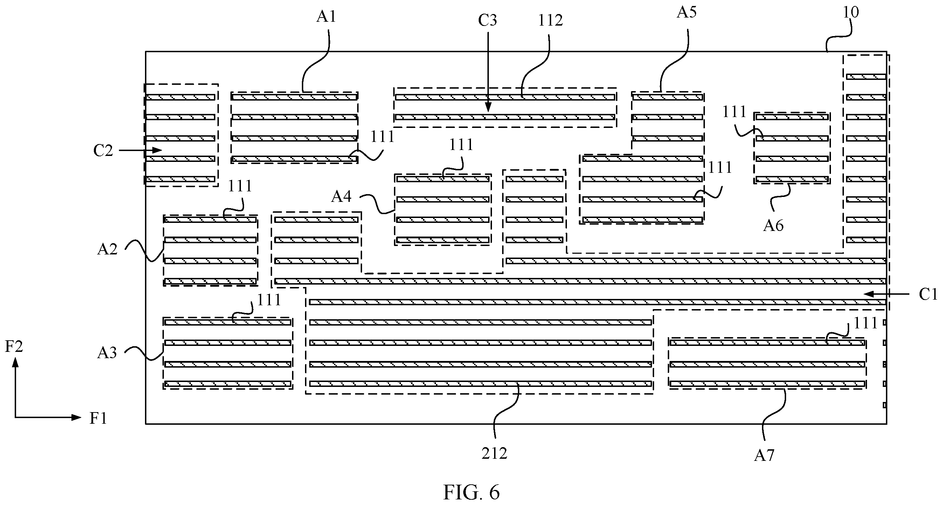

To describe the fin structure and the dummy fin structure formed in step S203 more clearly, numerals of the first strip-shaped regions and the second strip-shaped regions in FIG. 5a are omitted in FIG. 6. It can be obviously seen from FIG. 6 that each active region includes at least one strip-shaped fin structure 111, and there are a plurality of dummy fin structures 112 in the dummy regions C1 to C3 except the active regions. In addition, since the fins in the first strip-shaped regions and the second strip-shaped regions around the active region are removed, the formed fin structure 111 is disposed to be spaced from the dummy fin structure 112. Therefore, the formed dummy fin structure 112 does not affect performance of the fin structure 111. In addition, in the formed dummy regions, a shape of at least one dummy region is a polygon including at least five sides, and edges of the dummy region are embedded into a gap between two adjacent active regions. For example, the dummy region C1 is a polygon including 16 sides, and edges of the dummy region C1 are embedded into a gap between the active region A4 and the active region A5, so that an area of the dummy region is larger. There can be a larger quantity of dummy fin structures near the active region, uniformity of a subsequently formed isolation dielectric layer can be greatly improved, and the formed fin field effect transistor has good performance.

According to the chip manufacturing method provided in this embodiment of this application, the plurality of first strip-shaped regions and the plurality of second strip-shaped regions are disposed. The first strip-shaped region extends in the first direction, the second strip-shaped region extends in the second direction, and each active region is surrounded by the region formed by the first strip-shaped region and/or the second strip-shaped region. In this way, after the fins in the plurality of first strip-shaped regions and the plurality of second strip-shaped regions are removed, the fin structure of the fin field effect transistor can be formed in each active region, and the dummy fin structure can be formed in the dummy region except the active region, the first strip-shaped region, and the second strip-shaped region. The dummy fin structure is spaced from the fin structure in the active region by the first strip-shaped region and the second strip-shaped region, so that the dummy fin structure does not affect the performance of the fin structure in the active region. In addition, the dummy fin structure is disposed, so that the subsequently formed isolation dielectric layer can be uniform, quality of a subsequently formed film layer can be good, and drawbacks such as bending and dislocation of the fin structure due to uneven stress can be prevented. In addition, the shapes of the first strip-shaped region and the second strip-shaped region are simple. This reduces difficulty of a process for removing the fin, and does not affect a shape of the fin structure in the active region. Therefore, the fin field effect transistor obtained in the chip manufacturing method provided in this embodiment of this application has good performance.

During specific implementation, step S202 may include: as shown in FIG. 4, forming, on the substrate 10, the plurality of fins 11 extending in the first direction F1. In other words, the fins 11 formed on the substrate 10 have the same extension direction, and the extension direction of the fin 11 is consistent with the extension direction of the first strip-shaped region T1. In this way, in the subsequent step S203, it is easy to remove the fins 11 in the first strip-shaped region T1 and the second strip-shaped region T2, and precision of a process for removing the fin 11 is high. Therefore, in a process of removing the fins 11 in the first strip-shaped region T1 and the second strip-shaped region T2, the shape of the fin structure in the active region is not affected, so that the fin field effect transistor formed in the active region has better performance.

In this embodiment of this application, as shown in FIG. 3, each active region (for example, refer to the active region A7) may include at least two first edges a extending in the first direction F1, and at least two second edges b extending in the second direction F2. Each first strip-shaped region T1 is adjacent to a first edge a of at least one active region, and each second strip-shaped region T2 is adjacent to a second edge b of the at least one active region. In other words, the active region is close to the first strip-shaped region T1 and the second strip-shaped region T2 that surround the active region, so that after the fins in the first strip-shaped region T1 and the second strip-shaped region T2 are removed, the fin structure formed is substantially located within a range of each active region, and manufacturing precision of the fin structure is high. In addition, there may be a specific gap between the active region, and the first strip-shaped region T1 and the second strip-shaped region T2 that surround the active region. This can avoid affecting the shape of the fin structure in the active region in the process of removing the fins in the first strip-shaped region T1 and the second strip-shaped region T2 due to a process error, and can further ensure that the fin structure formed in the active region has good performance.

In actual application, still refer to FIG. 3. A width d1 of the first strip-shaped region T1 in the second direction F2 may be within a range of 0-2000 nm, and a width d2 of the second strip-shaped region T2 in the first direction F1 may be within a range of 0-2000 nm. In this way, the widths of the first strip-shaped region and the second strip-shaped region are appropriately set, a size of the dummy region except the active region, the first strip-shaped region, and the second strip-shaped region can be controlled, and the widths of the first strip-shaped region T1 and the second strip-shaped region T2 can be narrowed, so that an area of the fin removed in step S203 is smaller, an area of the formed dummy fin structure can be larger, and a process difference between a region except each active region and the active region is small. This can achieve effect of process optimization, and ensure that the formed fin field effect transistor has good performance.

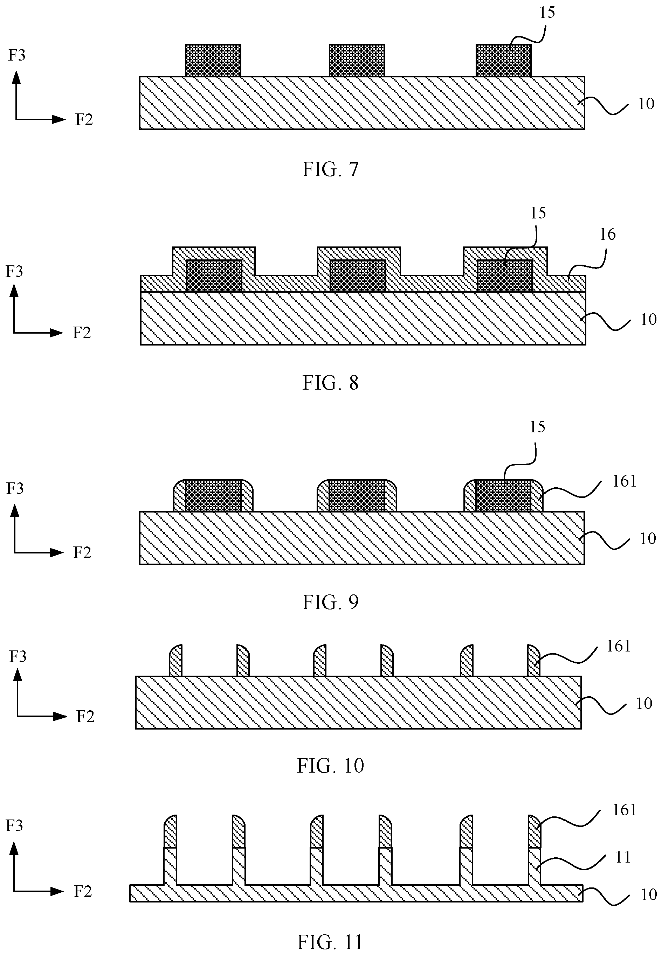

FIG. 7 to FIG. 12 are flowcharts of a manufacturing process of the fin according to this embodiment of this application. With reference to FIG. 7 to FIG. 12, step S202 may include the following steps.

Refer to FIG. 7. A plurality of mandrels 15 are formed on the substrate 10, and extension directions of the mandrels 15 are the same as extension directions of the fins to be formed. To be specific, a direction perpendicular to a paper surface in FIG. 7 may be the first direction, a horizontal direction in the figure may be the second direction F2, a vertical direction in the figure is the third direction F3, and the third direction F3 may be a direction perpendicular to the surface of the substrate 10. Optionally, a polycrystalline silicon material may be used to manufacture the mandrel 15. Certainly, another material may alternatively be used to manufacture the mandrel 15. This is not limited herein. In an actual process, an entire mandrel film layer may be formed on the substrate 10, and then the plurality of mandrels 15 located on the substrate 10 are obtained by using an etching process.

Refer to FIG. 8. A side wall layer 16 is formed on an entire surface of the mandrels 15. During specific implementation, a silicon nitride material may be used to manufacture the side wall layer 16, and certainly, another material may alternatively be used to manufacture the side wall layer 16. This is not limited herein. Refer to FIG. 9. Then, the side wall layer 16 is etched to form a plurality of side walls 161 located on side walls of the mandrels 15. In the actual process, the entire side wall layer may be etched, and due to geometrical effect of the side wall of the mandrel 15, a material on the side wall of the mandrel 15 is not etched, so that the side wall 161 is formed on the side wall of the mandrel 15.

The plurality of mandrels are removed by using an etching process, to obtain a structure shown in FIG. 10.

Refer to FIG. 11. The substrate 10 is etched by using the plurality of side walls 161 as shielding, to obtain patterns of the plurality of fins 11.

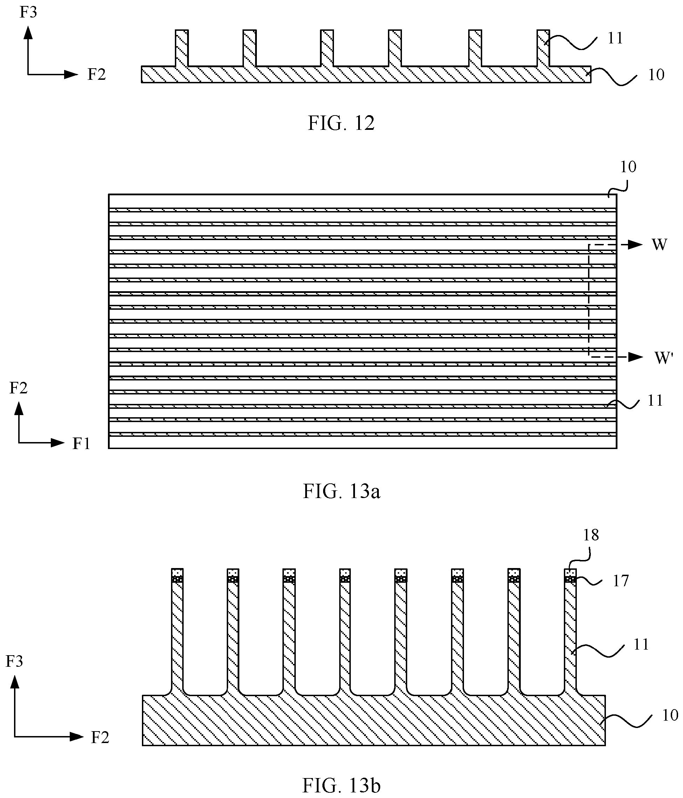

Refer to FIG. 12. The plurality of side walls are removed to obtain the plurality of fins 11.

In this embodiment of this application, the manufacturing procedure shown in FIG. 7 to FIG. 12 is used as an example to describe the manufacturing process of the fin. In the actual process, the fin may alternatively be manufactured in another manner. This is not limited herein.

FIG. 13a is a schematic of a structure of the plurality of fins formed on the substrate, and FIG. 13b is a schematic of a cross section at a dashed line WW' in FIG. 13a. As shown in FIG. 13a and FIG. 13b, in step S202, the plurality of fins 11 extending in the first direction F1 are formed on the substrate 10. After step S202 and before step S203, the method may further include: Form a buffer layer 17 on the fin 11, and form a protective layer 18 at the buffer layer 17. The buffer layer 17 and the protective layer 18 are formed on the fin 11, so that the fin 11 can be protected, and the fin 11 can be prevented from being damaged in a subsequent process.

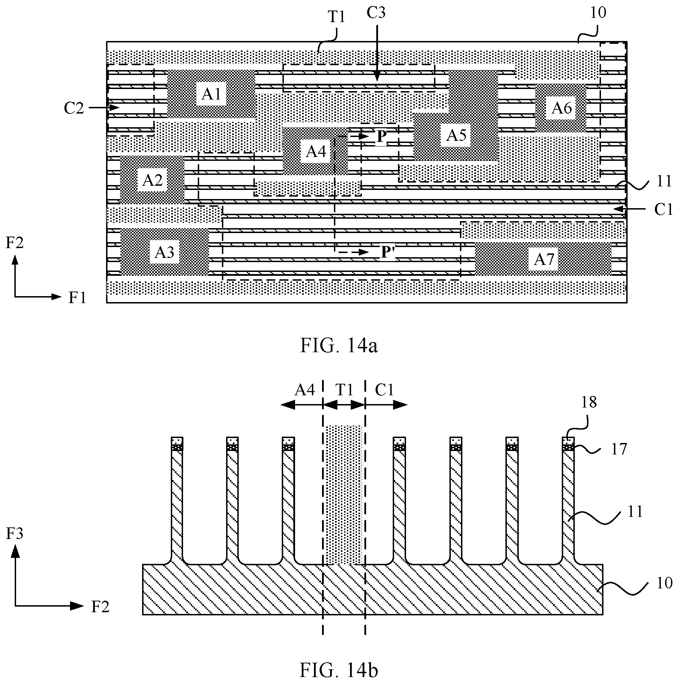

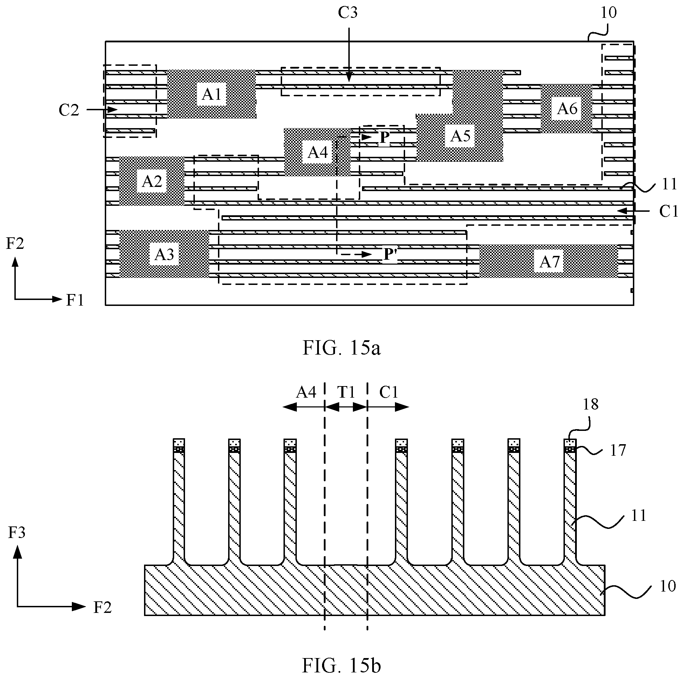

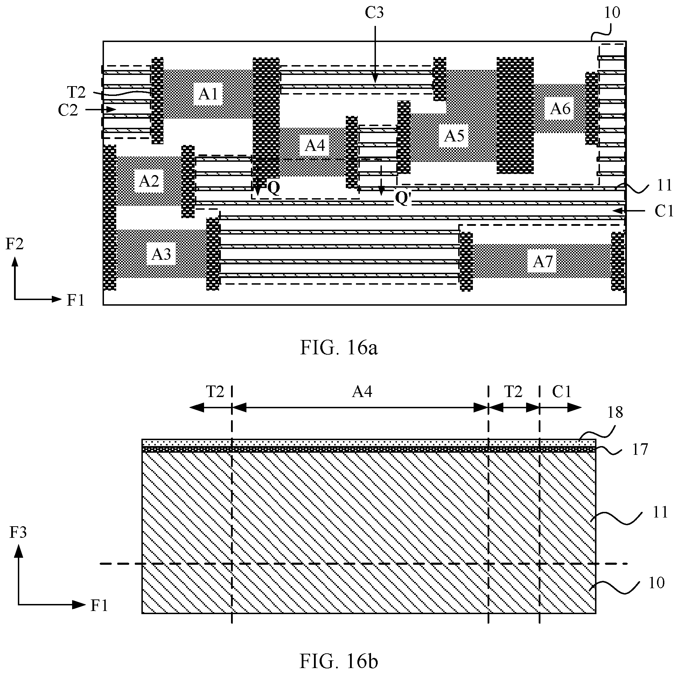

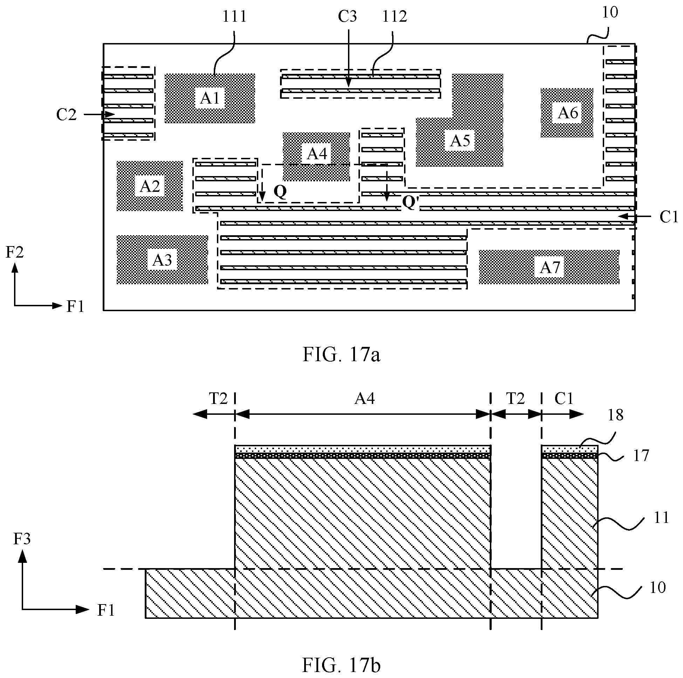

FIG. 14a is a schematic of a structure of a process of removing the fins in the plurality first strip-shaped regions, FIG. 14b is a schematic of a cross section at a dashed line PP' in FIG. 14a, FIG. 15a is a schematic of a structure obtained by removing the fins in the plurality of first strip-shaped regions, and FIG. 15b is a schematic of a cross section at a dashed line PP' in FIG. 15a. FIG. 16a is a schematic of a structure of a process of removing the fins in the plurality second strip-shaped regions, and FIG. 16b is a schematic of a cross section at a dashed line QQ' in FIG. 16a. FIG. 17a is a schematic of a structure obtained by removing the fins in the plurality of second strip-shaped regions, and FIG. 17b is a schematic of a cross section at a dashed line QQ' in FIG. 17a. The following describes in detail the process of removing the fins in the plurality of first strip-shaped regions and the plurality of second strip-shaped regions in step S203 with reference to the accompanying drawings.

Refer to FIG. 14a and FIG. 14b. The fins 11 in the plurality of first strip-shaped regions T1 may be removed by using a photolithography process and an etching process. Optionally, a photoresist layer (not shown in the figure) may be formed on an entire surface above the protective layer 18, and the photoresist layer in the plurality of first strip-shaped regions T1 is removed by using exposure and development processes, so that the photoresist layer protects regions except the plurality of first strip-shaped regions T1. Then, the fins 11 in the plurality of first strip-shaped regions T1 are removed by using the etching process, and then the remaining photoresist layer is removed. Structures shown in FIG. 15a and FIG. 15b are obtained by removing the fins 11 in the plurality of first strip-shaped regions T1.

Refer to FIG. 16a and FIG. 16b. The fins 11 in the plurality of second strip-shaped regions T2 may be removed by using a photolithography process and an etching process. Optionally, a photoresist layer (not shown in the figure) may be formed on an entire surface above the protective layer 18, and the photoresist layer in the plurality of second strip-shaped regions T2 is removed by using exposure and development processes, so that the photoresist layer protects regions except the plurality of second strip-shaped regions T2. Then, the fins 11 in the plurality of second strip-shaped regions T2 are removed by using the etching process, and then the remaining photoresist layer is removed. Structures shown in FIG. 17a and FIG. 17b are obtained by removing the fins 11 in the plurality of second strip-shaped regions T2. As shown in FIG. 17a and FIG. 17b, after the fins 11 in the plurality of first strip-shaped regions T1 and the plurality of second strip-shaped regions T2 are removed, the fin structure 111 is formed in each of the active regions A1 to A7, and the dummy fin structure 112 is formed in each of the dummy regions C1 to C3.

In an actual process, in the process of removing the fins in the first strip-shaped region and the second strip-shaped region, process precision and a process window can be improved by adjusting conditions of the photolithography process such as a light source and an exposure parameter and an etching process condition.

In this embodiment of this application, an example in which the fins in the plurality of first strip-shaped regions are first removed, and then, the fins in the plurality of second strip-shaped regions are removed is used for description. In the actual process, the fins in the plurality of second strip-shaped regions may alternatively be removed first, and then, the fins in the plurality of first strip-shaped regions are removed, or the fins in the plurality of first strip-shaped regions and the plurality of second strip-shaped regions may be removed at the same time. This is not limited herein.

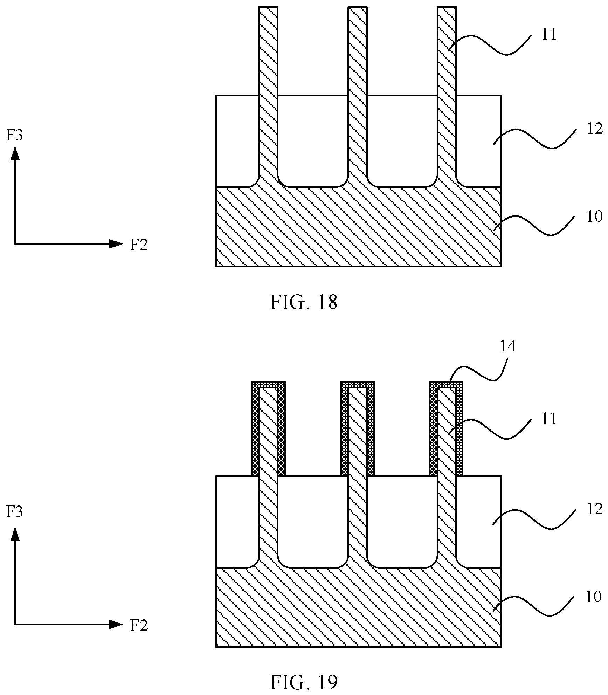

FIG. 18 to FIG. 20 are schematics of structures corresponding to steps in the chip manufacturing method according to this embodiment of this application. In some embodiments of this application, after step S203, the method may further include the following steps.

Doping processing is performed on the fin structure in each active region, to form a source region, a drain region, and a channel region in the fin structure, where the channel region may be located between the source region and the drain region. In actual application, before the doping processing is performed on the fin structure in the active region, the buffer layer and the protective layer on the fin structure may further be removed. In a process of doping the fin structure in the active region, the dummy fin structure in the dummy region may also be doped, so that the dummy region does not need to be shielded, thereby simplifying process difficulty.

As shown in FIG. 18, an isolation dielectric layer 12 is formed on the surface of the substrate 10, and the isolation dielectric layer 12 is etched, so that each fin structure 11 protrudes from the isolation dielectric layer 12. In this embodiment of this application, an entire surface of the isolation dielectric layer 12 may be approximately formed on the surface of the substrate 10. After the isolation dielectric layer 12 is etched, each dummy fin structure may further protrude from the isolation dielectric layer 12. Because there is the dummy fin structure in the dummy region except the active region, the first strip-shaped region, and the second strip-shaped region, the formed isolation dielectric layer 12 can be uniform.

As shown in FIG. 19, a gate dielectric layer 14 is formed on the fin structure 11 in each active region, and the gate dielectric layer 14 may cover the channel region in the fin structure 11.

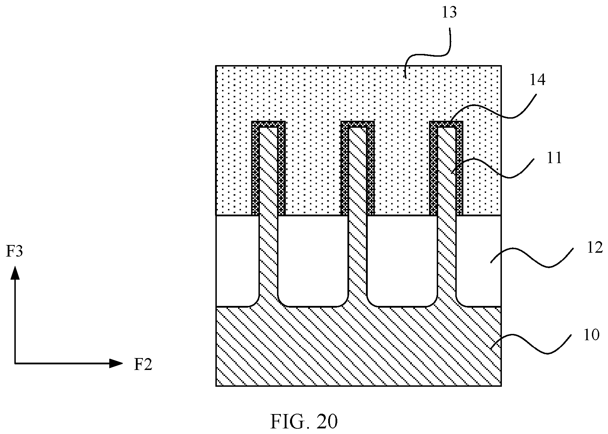

As shown in FIG. 20, a gate 13 is formed at the gate dielectric layer 14 in each active region, to obtain at least one fin field effect transistor shown in FIG. 1. Because the isolation dielectric layer 12 formed in this embodiment of this application is uniform, the gate dielectric layer 14 and the gate 13 that are subsequently formed have good quality, and the obtained fin field effect transistor has good performance.

In the actual process, the gate dielectric layer 14 and the gate 13 may also be formed on the dummy fin structure, so that a process difference between the active region and the dummy region is small. In addition, after the doping process, a source electrically connected to the source region in the fin structure may further be formed, and a drain electrically connected to the drain region in the fin structure may be formed, thereby connecting the source region and the drain region in the fin structure. Because the dummy fin structure only performs a function of enabling the subsequently formed isolation dielectric layer to be uniform, and does not need to be electrically connected to another component, a source region and a drain region in the dummy fin structure do not need to be connected.

Based on a same technical concept, an embodiment of this application further provides a chip. The chip may be various types of chips such as a central processing unit chip or an artificial intelligence chip. The chip may be manufactured by using any one of the foregoing manufacturing methods.

As shown in FIG. 5a, the chip may include a substrate 10 and a plurality of fin structures 111 and a plurality of dummy fin structures 112 located on the substrate 10. A surface of the substrate 10 may have a plurality of active regions (for example, the surface of the substrate 10 in FIG. 5a has active regions A1 to A7), a plurality of first strip-shaped regions T1 extending in a first direction F1, a plurality of second strip-shaped regions T2 extending in a second direction F2, and a plurality of dummy regions (for example, the surface of the substrate 10 in FIG. 5a has dummy regions C1 to C3), where the dummy regions C1 to C3 may be located in regions except the active regions, the plurality of first strip-shaped regions T1, and the plurality of second strip-shaped regions T2. The first direction F1 and the second direction F2 intersect each other, for example, the first direction F1 and the second direction F2 may be perpendicular to each other. At least one fin structure 111 is disposed in each active region on the substrate 10, at least one dummy fin structure 112 is disposed in each dummy region on the substrate 10, and each active region and the dummy region are spaced by the first strip-shaped region T1 and/or the second strip-shaped region T2.

In this embodiment of this application, each active region corresponds to at least one fin field effect transistor, that is, the chip includes at least one fin field effect transistor. Each active region and the dummy region are spaced by the first strip-shaped region T1 and/or the second strip-shaped region T2. Therefore, the fin structure 111 in each active region is disposed to be spaced from the dummy fin structure 112 in the dummy region, so that the dummy fin structure does not affect performance of the fin structure.

In addition, in the dummy regions on the surface of the substrate, a shape of at least one dummy region is a polygon including at least five sides, that is, the polygon may include five, six, or more sides, and may be set based on positions and shapes of the active regions on the surface of the substrate. The dummy region includes at least one sub-region, the sub-region is surrounded by at least three sides in the polygon, and the sub-region is embedded into a gap between two adjacent active regions. In a possible implementation, the sub-region may be a closed region enclosed by at least three sides in the polygon and a line segment (which may alternatively be a polyline, a curve, or the like) located in the dummy region.

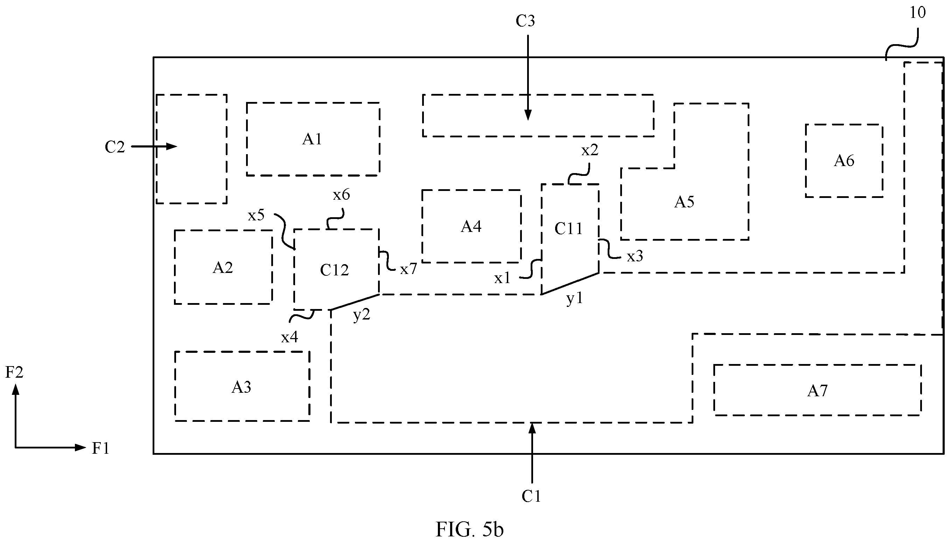

FIG. 5b is a partially enlarged schematic of FIG. 5a. To clearly describe the sub-region in the dummy region, figures of the fin structure, the dummy fin structure, the first strip-shaped region, and the second strip-shaped region are omitted in FIG. 5b. With reference to FIG. 5a and FIG. 5b, for example, the dummy region C1 in FIG. 5a is a polygon including 16 sides. The dummy region C1 may include a sub-region C11 and a sub-region C12. The sub-region C11 may be a closed region enclosed by sides x1, x2, and x3 of the dummy region C1 and a line segment y1 located in the dummy region C1, and the sub-region C11 is embedded into a gap between the active regions A4 and A5. The sub-region C12 may be a closed region enclosed by sides x4, x5, x6 and x7 of the dummy region C1 and a line segment y2 located in the dummy region C1, and the sub-region C12 is embedded into the gap between the active regions A2, A1 and A4.

In this way, space between two adjacent active regions can be fully utilized, and a larger quantity of dummy fin structures can be disposed near the active region, so that an area of the dummy region can be larger, uniformity of a subsequently formed isolation dielectric layer can be greatly improved, further, a subsequently formed film layer has good quality, and the fin field effect transistor has good performance.

Still refer to FIG. 5a. At least one of the plurality of dummy regions on the surface of the substrate at least semi-encloses one active region. For example, in FIG. 5a, the dummy region C1 semi-encloses the active regions A4, A5, and A7. Certainly, the dummy region may semi-enclose one, two, or more active regions. Alternatively, the dummy region may fully enclose at least one active region. This is not limited herein. It may be understood that the dummy region at least semi-enclosing one active region means that the dummy region encloses at least two sides of the active region.

Optionally, at least one of the plurality of dummy regions on the surface of the substrate may be a rectangle. For example, the dummy regions C2 and C3 in FIG. 5a are rectangular.

During specific implementation, as shown in FIG. 5a, at least one of the plurality of active regions on the surface of the substrate 10 is rectangular (for example, the active region A1 in FIG. 5a is rectangular), and the active region and the dummy region are spaced by two first strip-shaped regions T1 and two second strip-shaped regions T2. Certainly, the active region may alternatively be in another shape. For example, in FIG. 5a, the active region A5 is in an "L" shape, and quantities and positions of the first strip-shaped regions and the second strip-shaped regions that surround the active region may be set based on the shape of the active region.

In this embodiment of this application, as shown in FIG. 1, the chip may further include an isolation dielectric layer 12 located on the substrate 10, and the fin structure 111 protrudes from a side that is of the isolation dielectric layer 12 and that is away from the substrate 10. In addition, the chip may further include a gate dielectric layer 14 and a gate 13 in the active region located on the substrate 10. The gate 13 is located on a side that is of the fin structure 111 and that is away from the substrate 10, and the gate dielectric layer 14 is located between the fin structure 111 and the gate 13. The fin structure 111 includes a source region, a drain region, and a channel region, the channel region is located between the source region and the drain region, the gate 13 covers a position of the channel region in the fin structure 11, and a top surface and two side surfaces of the fin structure 111 are both surrounded by the gate 13. Therefore, the gate 13 can control the channel region through the top surface and the two side surfaces of the fin structure 111, so that the fin field effect transistor has advantages such as a strong gate control capability, a small device size, and low power consumption.

Based on a same technical concept, an embodiment of this application further provides an electronic device. The electronic device may be a device like a smartphone, a smart television, or a notebook computer. The electronic device may include any one of the chips and a printed circuit board. Because the fin field effect transistor in the chip has good performance, the electronic device including the chip also has good performance.

Although some embodiments of this application have been described, a person skilled in the art can make changes and modifications to these embodiments once the basic inventive concept is learnt. Therefore, the following claims are intended to be construed as to cover the preferred embodiments and all changes and modifications falling within the scope of this application.

Clearly, a person skilled in the art can make various modifications and variations to embodiments of this application without departing from the scope of embodiments of this application.

## Claims

1. A chip, comprising a substrate and a plurality of fin structures and a plurality of dummy fin structures that are located on the substrate, wherein
a surface of the substrate has a plurality of active regions, a plurality of first strip-shaped regions extending in a first direction, a plurality of second strip-shaped regions extending in a second direction, and a plurality of dummy regions; and the first direction and the second direction intersect each other;
at least one fin structure is disposed in each active region on the substrate;
at least one dummy fin structure is disposed in each dummy region on the substrate;
each active region and the dummy region are spaced by the first strip-shaped and/or the second strip-shaped; and
a shape of at least one of the plurality of dummy regions is a polygon comprising at least five sides, the dummy region comprises at least one sub-region, the sub-region is surrounded by at least three of the at least five sides, and the sub-region is embedded into a gap between two adjacent active regions.

2. The chip according to claim 1, wherein at least one of the plurality of dummy regions at least semi-encloses one active region.

3. The chip according to claim 1, wherein at least one of the plurality of dummy regions is rectangular.

4. The chip according to any one of claims 1 to 3, wherein at least one of the plurality of active regions is rectangular, and the active region and the dummy region are spaced by two first strip-shaped regions and two second strip-shaped regions.

5. The chip according to any one of claims 1 to 4, further comprising an isolation dielectric layer located on the substrate; and
the fin structure protrudes from a side that is of the isolation dielectric layer and that is away from the substrate.

6. The chip according to claim 5, further comprising a gate dielectric layer and a gate in the active region located on the substrate;
the gate is located on a side that is of the fin structure and that is away from the substrate, and the gate dielectric layer is located between the fin structure and the gate; and
the fin structure comprises a source region, a drain region, and a channel region, the channel region is located between the source region and the drain region, and the gate covers a position of the channel region in the fin structure.

7. An electronic device, comprising the chip according to any one of claims 1 to 6, and a printed circuit board.

8. A chip manufacturing method, comprising:
providing a substrate, wherein a surface of the substrate has a plurality of active regions, a plurality of first strip-shaped regions extending in a first direction, a plurality of second strip-shaped regions extending in a second direction, and a plurality of dummy regions; the first direction and the second direction intersect each other; and each active region corresponds to at least one fin field effect transistor to be formed, and each active region is surrounded by a region formed by the first strip-shaped region and/or the second strip-shaped region;
forming a plurality of fins on the substrate; and
removing fins in the plurality of first strip-shaped regions and the plurality of second strip-shaped regions to form a fin structure of a fin field effect transistor in each active region, and form a dummy fin structure in each dummy region, wherein the fin structure is some fins located in the active region, and the dummy fin structure is some fins located in the dummy region.

9. The manufacturing method according to claim 8, wherein the forming a plurality of fins on the substrate comprises:
forming, on the substrate, the plurality of fins extending in the first direction.

10. The manufacturing method according to claim 8, wherein each active region comprises at least two first edges extending in the first direction, and at least two second edges extending in the second direction; and
each first strip-shaped region is adjacent to the first edge of at least one active region, and each second strip-shaped region is adjacent to the second edge of the at least one active region.

11. The manufacturing method according to claim 10, wherein a width of the first strip-shaped region in the second direction is within a range of 0-2000 nm, and a width of the second strip-shaped region in the first direction is within a range of 0-2000 nm.

12. The manufacturing method according to claim 10, wherein the removing fins in the plurality of first strip-shaped regions and the plurality of second strip-shaped regions comprises:
removing fins in the plurality of first strip-shaped regions by using a photolithography process and an etching process; and
removing fins in the plurality of second strip-shaped regions by using a photolithography process and an etching process.

13. The manufacturing method according to any one of claims 8 to 12, wherein the forming a plurality of fins on the substrate comprises:
forming a plurality of mandrels on the substrate, wherein extension directions of the mandrels are the same as extension directions of the fins to be formed;
forming a side wall layer on an entire surface of the mandrels, and etching the side wall layer to form a plurality of side walls located on side walls of the mandrels;
removing the plurality of mandrels by using an etching process;
etching the substrate by using the plurality of side walls as shielding, to obtain patterns of the plurality of fins; and
removing the plurality of side walls to obtain the plurality of fins.

14. The manufacturing method according to any one of claims 8 to 13, wherein after the fin structure of the fin field effect transistor is formed, the method further comprises:
performing doping processing on the fin structure in each active region, to form a source region, a drain region, and a channel region in the fin structure;
forming an isolation dielectric layer on the surface of the substrate, and etching the isolation dielectric layer, so that each fin structure protrudes from the isolation dielectric layer;
forming a gate dielectric layer on the fin structure in each active region; and
forming a gate at the gate dielectric layer in each active region, to obtain at least one fin field effect transistor.

## Patentansprüche

1. Chip, umfassend ein Substrat und eine Vielzahl von Rippenstrukturen und eine Vielzahl von Dummy-Rippenstrukturen, die sich auf dem Substrat befinden, wobei
eine Oberfläche des Substrats eine Vielzahl aktiver Regionen, eine Vielzahl erster streifenförmiger Regionen, die sich in eine erste Richtung erstrecken, eine Vielzahl zweiter streifenförmiger Regionen, die sich in eine zweite Richtung erstrecken, und eine Vielzahl von Dummy-Regionen aufweist; und sich die erste Richtung und die zweite Richtung überschneiden; mindestens eine Rippenstruktur in jeder aktiven Region auf dem Substrat angeordnet ist;
mindestens eine Dummy-Rippenstruktur in jeder Dummy-Region auf dem Substrat angeordnet ist;
jede aktive Region und die Dummy-Region durch die erste streifenförmige und/oder die zweite streifenförmige beabstandet sind; und
eine Form mindestens einer der Vielzahl von Dummy-Regionen ein Vieleck ist, das mindestens fünf Seiten umfasst, die Dummy-Region mindestens eine Unterregion umfasst, die Unterregion durch mindestens drei der mindestens fünf Seiten umgeben ist und die Unterregion in eine Lücke zwischen zwei benachbarten aktiven Regionen eingebettet ist.

2. Chip nach Anspruch 1, wobei mindestens eine der Vielzahl von Dummy-Regionen eine aktive Region mindestens halb umschließt.

3. Chip nach Anspruch 1, wobei mindestens eine der Vielzahl von Dummy-Regionen rechteckig ist.

4. Chip nach einem der Ansprüche 1 bis 3, wobei mindestens eine der Vielzahl aktiver Regionen rechteckig ist und die aktive Region und die Dummy-Region durch zwei erste streifenförmige Regionen und zwei zweite streifenförmige Regionen beabstandet sind.

5. Chip nach einem der Ansprüche 1 bis 4, ferner umfassend eine dielektrische Isolationsschicht, die sich auf dem Substrat befindet; und
wobei die Rippenstruktur aus einer Seite hervorspringt, die der dielektrischen Isolationsschicht angehört und die von dem Substrat weg ist.

6. Chip nach Anspruch 5, ferner umfassend eine dielektrische Gate-Schicht und ein Gate in der aktiven Region, die sich auf dem Substrat befindet;
wobei sich das Gate auf einer Seite befindet, die der Rippenstruktur angehört und die von dem Substrat weg ist, und sich die dielektrische Gate-Schicht zwischen der Rippenstruktur und dem Gate befindet; und
die Rippenstruktur eine Source-Region, eine Drain-Region und eine Kanalregion umfasst, sich die Kanalregion zwischen der Source-Region und der Drain-Region befindet und das Gate eine Position der Kanalregion in der Rippenstruktur abdeckt.

7. Elektronische Vorrichtung, umfassend den Chip nach einem der Ansprüche 1 bis 6 und eine Leiterplatte.

8. Chip-Herstellungsverfahren, umfassend:
Bereitstellen eines Substrats, wobei eine Oberfläche des Substrats eine Vielzahl aktiver Regionen, eine Vielzahl erster streifenförmiger Regionen, die sich in eine erste Richtung erstrecken, eine Vielzahl zweiter streifenförmiger Regionen, die sich in eine zweite Richtung erstrecken, und eine Vielzahl von Dummy-Regionen aufweist; sich die erste Richtung und die zweite Richtung überschneiden; und jede aktive Region mindestens einem zu bildenden Rippen-Feldeffekttransistor entspricht und jede aktive Region durch eine Region umgeben wird, die durch die erste streifenförmige Region und/oder die zweite streifenförmige Region gebildet wird;
Bilden einer Vielzahl von Rippen auf dem Substrat; und
Entfernen von Rippen in der Vielzahl erster streifenförmiger Regionen und der Vielzahl zweiter streifenförmiger Regionen, um eine Rippenstruktur eines Rippen-Feldeffekttransistors in jeder aktiven Region zu bilden und eine Dummy-Rippenstruktur in jeder Dummy-Region zu bilden, wobei die Rippenstruktur aus einigen Rippen besteht, die sich in der aktiven Region befinden, und die Dummy-Rippenstruktur aus einigen Rippen besteht, die sich in der Dummy-Region befinden.

9. Herstellungsverfahren nach Anspruch 8, wobei das Bilden einer Vielzahl von Rippen auf dem Substrat Folgendes umfasst:
Bilden, auf dem Substrat, der Vielzahl von Rippen, die sich in die erste Richtung erstrecken.

10. Herstellungsverfahren nach Anspruch 8, wobei jede aktive Region mindestens zwei erste Kanten, die sich in die erste Richtung erstrecken, und mindestens zwei zweite Kanten, die sich in die zweite Richtung erstrecken, umfasst; und
jede erste streifenförmige Region zu der ersten Kante mindestens einer aktiven Region benachbart ist und jede zweite streifenförmige Region zu der zweiten Kante der mindestens einen aktiven Region benachbart ist.

11. Herstellungsverfahren nach Anspruch 10, wobei eine Breite der ersten streifenförmigen Region in der zweiten Richtung innerhalb eines Bereichs von 0-2000 nm liegt und eine Breite der zweiten streifenförmigen Region in der ersten Richtung innerhalb eines Bereichs von 0-2000 nm liegt.

12. Herstellungsverfahren nach Anspruch 10, wobei das Entfernen von Rippen in der Vielzahl erster streifenförmiger Regionen und der Vielzahl zweiter streifenförmiger Regionen Folgendes umfasst:
Entfernen von Rippen in der Vielzahl erster streifenförmiger Regionen unter Verwendung eines Photolithographieprozesses und eines Ätzprozesses; und
Entfernen von Rippen in der Vielzahl zweiter streifenförmiger Regionen unter Verwendung eines Photolithographieprozesses und eines Ätzprozesses.

13. Herstellungsverfahren nach einem der Ansprüche 8 bis 12, wobei das Bilden einer Vielzahl von Rippen auf dem Substrat Folgendes umfasst:
Bilden einer Vielzahl von Dornen auf dem Substrat, wobei Erstreckungsrichtungen der Dorne die gleichen wie Erstreckungsrichtungen der zu bildenden Rippen sind;
Bilden einer Seitenwandschicht auf einer gesamten Oberfläche der Dorne und Ätzen der Seitenwandschicht, um eine Vielzahl von Seitenwänden zu bilden, die sich auf den Seitenwänden der Dorne befinden;
Entfernen der Vielzahl von Dornen unter Verwendung eines Ätzprozesses;
Ätzen des Substrats unter Verwendung der Vielzahl von Seitenwänden als Abschirmung, um Muster der Vielzahl von Rippen zu erlangen; und
Entfernen der Vielzahl von Seitenwänden, um die Vielzahl von Rippen zu erlangen.

14. Herstellungsverfahren nach einem der Ansprüche 8 bis 13, wobei das Verfahren, nachdem die Rippenstruktur des Rippen-Feldeffekttransistors gebildet ist, ferner Folgendes umfasst:
Durchführen eines Dotierungsprozesses an der Rippenstruktur in jeder aktiven Region, um eine Source-Region, eine Drain-Region und eine Kanalregion in der Rippenstruktur zu bilden;
Bilden einer dielektrischen Isolationsschicht auf der Oberfläche des Substrats und Ätzen der dielektrischen Isolationsschicht, sodass jede Rippenstruktur aus der dielektrischen Isolationsschicht hervorspringt;
Bilden einer dielektrischen Gate-Schicht auf der Rippenstruktur in jeder aktiven Region; und
Bilden eines Gates an der dielektrischen Gate-Schicht in jeder aktiven Region, um mindestens einen Rippen-Feldeffekttransistor zu erlangen.

## Revendications

1. Puce, comprenant un substrat et une pluralité de structures d'ailettes et une pluralité de structures d'ailettes factices qui sont situées sur le substrat, dans laquelle
une surface du substrat a une pluralité de régions actives, une pluralité de premières régions en forme de bande se prolongeant dans une première direction, une pluralité de secondes régions en forme de bande se prolongeant dans une seconde direction, et une pluralité de régions factices ; et la première direction et la seconde direction se croisent ;
au moins une structure d'ailette est disposée dans chaque région active sur le substrat ;
au moins une structure d'ailette factice est disposée dans chaque région factice sur le substrat ;
chaque région active et la région factice sont espacées par la première forme de bande et/ou la seconde forme de bande ; et
une forme d'au moins une de la pluralité de régions factices est un polygone comprenant au moins cinq côtés, la région factice comprend au moins une sous-région, la sous-région est entourée par au moins trois des au moins cinq côtés, et la sous-région est intégrée dans un espace entre deux régions actives adjacentes.

2. Puce selon la revendication 1, dans laquelle au moins une de la pluralité de régions factices semi-enferme au moins une région active.

3. Puce selon la revendication 1, dans laquelle au moins une de la pluralité de régions factices est rectangulaire.

4. Puce selon l'une quelconque des revendications 1 à 3, dans laquelle au moins une de la pluralité de régions actives est rectangulaire, et la région active et la région factice sont espacées par deux premières régions en forme de bande et deux secondes régions en forme de bande.

5. Puce selon l'une quelconque des revendications 1 à 4, comprenant également une couche diélectrique d'isolation située sur le substrat ; et
la structure d'ailette fait saillie d'un côté qui est celui de la couche diélectrique d'isolation et qui est éloigné du substrat.

6. Puce selon la revendication 5, comprenant également une couche diélectrique de grille et une grille dans la région active située sur le substrat ;
la grille est située sur un côté qui est celui de la structure d'ailette et qui est éloigné du substrat, et la couche diélectrique de grille est située entre la structure d'ailette et la grille ; et
la structure d'ailette comprend une région source, une région de drain et une région de canal, la région de canal est située entre la région source et la région de drain, et la grille recouvre une position de la région de canal dans la structure d'ailette.

7. Dispositif électronique, comprenant la puce selon l'une quelconque des revendications 1 à 6, et une carte de circuit imprimé.

8. Procédé de fabrication de puce, comprenant :
la fourniture d'un substrat, dans lequel une surface du substrat a une pluralité de régions actives, une pluralité de premières régions en forme de bande se prolongeant dans une première direction, une pluralité de secondes régions en forme de bande se prolongeant dans une seconde direction, et une pluralité de régions factices ; la première direction et la seconde direction se croisent ; et chaque région active correspond à au moins un transistor à effet de champ à ailettes à former, et chaque région active est entourée par une région formée par la première région en forme de bande et/ou la seconde région en forme de bande ;
la formation d'une pluralité d'ailettes sur le substrat ; et
le fait de retirer les ailettes dans la pluralité de premières régions en forme de bande et la pluralité de secondes régions en forme de bande pour former une structure d'ailette d'un transistor à effet de champ à ailettes dans chaque région active, et former une structure d'ailette factice dans chaque région factice, dans lequel la structure d'ailette est constituée de certaines ailettes situées dans la région active, et la structure d'ailette factice est constituée de certaines ailettes situées dans la région factice.

9. Procédé de fabrication selon la revendication 8, dans lequel la formation d'une pluralité d'ailettes sur le substrat comprend :
la formation, sur le substrat, de la pluralité d'ailettes se prolongeant dans la première direction.

10. Procédé de fabrication selon la revendication 8, dans lequel chaque région active comprend au moins deux premiers bords se prolongeant dans la première direction, et au moins deux seconds bords se prolongeant dans la seconde direction ; et
chaque première région en forme de bande est adjacente au premier bord d'au moins une région active, et chaque seconde région en forme de bande est adjacente au second bord de l'au moins une région active.

11. Procédé de fabrication selon la revendication 10, dans lequel une largeur de la première région en forme de bande dans la seconde direction est comprise dans une plage de 0 à 2 000 nm, et une largeur de la seconde région en forme de bande dans la première direction est comprise dans une plage de 0 à 2 000 nm.

12. Procédé de fabrication selon la revendication 10, dans lequel le fait de retirer les ailettes dans la pluralité de premières régions en forme de bande et la pluralité de secondes régions en forme de bande comprend :
le fait de retirer les ailettes dans la pluralité de premières régions en forme de bande à l'aide d'un procédé de photolithographie et d'un procédé de gravure ; et
le fait de retirer les ailettes dans la pluralité de secondes régions en forme de bande à l'aide d'un procédé de photolithographie et d'un procédé de gravure.

13. Procédé de fabrication selon l'une quelconque des revendications 8 à 12, dans lequel la formation d'une pluralité d'ailettes sur le substrat comprend :
la formation d'une pluralité de mandrins sur le substrat, dans lequel les directions d'extension des mandrins sont les mêmes que les directions d'extension des ailettes à former ;
la formation d'une couche de paroi latérale sur toute une surface des mandrins, et la gravure de la couche de paroi latérale pour former une pluralité de parois latérales situées sur les parois latérales des mandrins ;
le fait de retirer la pluralité de mandrins à l'aide d'un procédé de gravure ;
la gravure du substrat à l'aide de la pluralité de parois latérales comme blindage, pour obtenir des motifs de la pluralité d'ailettes ; et
le fait de retirer la pluralité de parois latérales pour obtenir la pluralité d'ailettes.

14. Procédé de fabrication selon l'une quelconque des revendications 8 à 13, dans lequel, après la formation de la structure d'ailette du transistor à effet de champ à ailettes, le procédé comprend également :
la réalisation d'un traitement de dopage sur la structure d'ailette dans chaque région active, pour former une région source, une région de drain et une région de canal dans la structure d'ailette ;
la formation d'une couche diélectrique d'isolation sur la surface du substrat, et la gravure la couche diélectrique d'isolation, de sorte que chaque structure d'ailette fait saillie de la couche diélectrique d'isolation ;
la formation d'une couche diélectrique de grille sur la structure d'ailette dans chaque région active ; et
la formation d'une grille au niveau de la couche diélectrique de grille dans chaque région active, pour obtenir au moins un transistor à effet de champ à ailettes.
